# EUROPEAN PATENT APPLICATION

(11) **EP 4 746 032 A1**
(43) Date of publication of application: **20.05.2026**
(21) Application number: 24853726.8
(22) Date of filing: 12.08.2024
(51) Int. Cl.: H01L 21/677, H01J 37/305, H01J 37/32, E05F 15/603

(54) **DOOR DRIVING MECHANISM, PROCESS CHAMBER, AND SEMICONDUCTOR PROCESS DEVICE**

(30) Priority: 17.08.2023 CN 202311040697
(71) Applicant: Beijing NAURA Microelectronics Equipment Co., Ltd., Beijing 100176 (CN)
(72) Inventor: FAN, Yingxu, Beijing 100176 (CN); TANG, Xiwen, Beijing 100176 (CN)
(74) Representative: Cohausz & Florack
(86) International application number: PCT/CN2024/111357
(87) International publication number: WO 2025/036317

(57) **Abstract**

The present disclosure provides a gate drive mechanism, a process chamber, and semiconductor processing equipment. The gate drive mechanism includes a first drive apparatus, a second drive apparatus, and a connector. The connector is configured to be connected to a gate and driving-connected to the first drive apparatus and the second drive apparatus. The first drive apparatus is configured to drive the connector to move along a first direction to allow the connector to drive the gate to move along the first direction. The second drive apparatus is configured to drive the connector to move along a second direction, the second direction intersecting with the first direction, to allow the connector to drive the gate to move along the second direction relative to the first drive apparatus. By providing the second drive apparatus, the gate drive mechanism of the present disclosure can allow the gate to move horizontally. Thus, the gate can cover the liner structure to realize sealing or separate the gate from the liner. While the seal performance of the gate is ensured, the collisions and scratches between the gate and the liner structure are effectively avoided.

## Description

### TECHNICAL FIELD

The present disclosure generally relates to the semiconductor manufacturing technology field and, more particularly, to a gate drive mechanism, a process chamber, and semiconductor processing equipment.

### BACKGROUND

In the field of semiconductor manufacturing, a process chamber is a very important piece of equipment, and semiconductor processing equipment requires a process chamber. Taking an etching machine as an example, a process chamber is provided in the etching machine, an upper electrode is arranged at the top of the process chamber, a liftable lower electrode is arranged inside the process chamber, and a liner is arranged at the top of the process chamber. The top of the liner is connected to the upper electrode, and an assembly port cooperating with the lower electrode is arranged at the bottom. When the lower electrode rises to the assembly port, the upper electrode, the inner wall of the liner, and the lower electrode together form an inner chamber configured to perform the etching process. An outer chamber is formed between the outer wall of the liner and the inner wall of the process chamber.

To facilitate a wafer to enter and exit the process chamber, a transfer port communicating with the outer chamber is arranged at the outer wall of the process chamber, and a wafer transfer opening communicating with the inner chamber is arranged at the liner. The transfer port corresponds to the wafer transfer opening. The wafer is transferred through the transfer port and the wafer transfer opening by the manipulator. Since the entirety of the inner chamber needs to be ensured during the etching process, a liftable inner gate mechanism is arranged in the outer chamber. During the etching process, the inner gate can shield the wafer transfer opening to allow the inner chamber to form a nearly complete circle. Thus, the uniformity of the inner process environment of the chamber is improved, and the etching uniformity is improved.

However, in the existing technology, since the inner gate mechanism moves up and down while attached to the outer wall of the liner during opening and closing, to avoid friction between the inner gate and the outer wall of the liner during opening and closing, a clearance is provided between the inner gate and the liner. Therefore, the inner chamber is not completely sealed, which is unfavorable for stable and uniform airflow, and the plasma is not fully shielded, presenting a risk of plasma leakage. Moreover, although there is a clearance between the inner gate and the liner, because the lifting rod is relatively long, the lifting of the inner gate is unstable. During prolonged lifting and lowering operations, a risk that the guide rod is inclined and the lifting rod scratches and collides with the inner wall of the reaction chamber or the liner exists. Therefore, how to ensure the sealing effect of the inner chamber while effectively preventing friction and collision between the inner gate and the liner is a problem that needs to be solved quickly.

### SUMMARY

The purpose of the present disclosure is to solve the problem that the inner gate and the liner are not able to be completely sealed, and a collision risk exists. The present disclosure provides a gate drive mechanism, a process chamber, and semiconductor processing equipment.

To realize the purpose of the present disclosure, a gate drive mechanism is provided. The gate drive mechanism includes:
a first drive apparatus;
a second drive apparatus; and
a connector configured to be connected to a gate and driving-connected to the first drive apparatus and the second drive apparatus.

The first drive apparatus is configured to drive the connector to move along a first direction to allow the connector to drive the gate to move along the first direction.

The second drive apparatus is configured to drive the connector to move along a second direction, the second direction intersecting with the first direction, to allow the connector to drive the gate to move along the second direction relative to the first drive apparatus.

In some embodiments, the second drive apparatus includes:
a second shell body including an installation opening and an installation space communicating with the installation opening and configured to be mounted at a support object, the support object being configured to close the installation opening; and
a second driver arranged in the installation space and configured to provide a drive force in the second direction to drive the connector to move along the second direction.

In some embodiments, the second drive apparatus further includes a transmission assembly connected between the second driver and the connector. The transmission assembly includes:
a connection board movably arranged in the installation space and driving-connected to the second driver; and
a guidance shaft passing through the second shell body, an axis of the guidance shaft being arranged along the second direction and being movable along the second direction relative to the second shell body, a first end of the guidance shaft being in the installation space and fixedly connected to the connection board, a second end of the guidance shaft being arranged outside of the second shell body, an installation base being arranged at the guidance shaft, the connector being arranged at the installation base, and the installation base driven by the guidance shaft being movable along the second direction.

In the first direction, the connector and the installation base move relatively.

In the second direction, the connector and the installation base are relatively fixed to allow the installation base to drive the connector to move along the second direction.

In some embodiments, the second shell body includes:
a first accommodation member including a first end and a second end arranged oppositely along the second direction, the first end of the first accommodation member being connected to the support object, and the installation opening being provided at the first end of the first accommodation member; and
a second accommodation member including a first end and a second end arranged oppositely along the second direction, the first end of the second accommodation member being connected to the second end of the first accommodation member.

The first accommodation member communicates with the second accommodation member internally to form the installation space.

The connection board is movably arranged in the first accommodation member along the second direction.

The second driver is arranged in the second accommodation member.

In some embodiments, a step structure is formed at a connection position between the first end of the second accommodation member and the second end of the first accommodation member, a guidance hole communicating with the first accommodation member internally is arranged at the first accommodation member along the second direction, the guidance hole is formed a the step structure, and the guidance shaft passes through the guidance hole from inside along the second direction.

In some embodiments, the connection board includes a board body and a connection arm, the connection arm is arranged at an outer periphery of the board body, the board body and the second driver are driving-connected, and the connection is connected to the guidance shaft.

In some embodiments, a first installation groove is arranged in the first accommodation member, a groove opening of the first installation groove is located on a surface of a first end of the first accommodation member to form the installation opening, a groove bottom of the first installation groove is located at a second end of the first accommodation member, the first installation groove includes a main groove body and a secondary groove body, and the secondary groove body is arranged at a periphery of the main groove.

A second installation groove is arranged in the second accommodation member, a groove opening of the second installation groove is located at a groove bottom of the second installation groove and communicates with the main groove body, the groove bottom of the second installation groove is located at a second end of the second accommodation member, and the first installation groove and the second installation groove form the installation space together.

The board body is arranged in the main groove body, and the connection arm is arranged in the secondary groove body.

In some embodiments, the guidance shaft is sealed from the second shell body.

In some embodiments, a positioning column is arranged in the second shell body along the second direction. A positioning hole is formed on the connection board, the positioning column is arranged in the positioning hole, and the connection board is movable relative to the positioning column to perform positioning and guidance through cooperation between the positioning column and the positioning hole.

In some embodiments, two positioning columns are provided and arranged in the second accommodation member at an interval, and a position-limiting space for mounting the second driver is formed between the two neighboring positioning columns.

In some embodiments, the connector includes a connection rod, an installation hole passes through the installation base along the first direction, the connection rod passes through the installation hole, and the connector is movable in the installation hole along the first direction.

In some embodiments, the first drive apparatus includes:
a first driver arranged movably along the first direction, a first slider being arranged at the first driver.
A second slider is arranged at the connector, the first slider and the second slider position-limiting-cooperate in the first direction, the first slider and the second slider slide-cooperate in the second direction to allow the first driver to drive the connector to move along the first direction, and the connector slides in the second direction relative to the first driver.

In some embodiments, the connector includes:
a connection rod, a first end of the connection rod being connected to the gate; and
a sliding board fixedly connected to a second end of the connection rod, the second slider being arranged at the sliding board.

The first slider is a sliding track or sliding groove arranged in the second direction, and the second slider is a sliding groove or a sliding track matching the first slider.

In some embodiments, the first drive apparatus further includes:
a bracket, the first driver being movably arranged at the bracket along the first direction; and
a detection apparatus arranged at the bracket and configured to detect apposition of the first driver.

In some embodiments, the gate drive mechanism further includes:
a first connector connected to a support object, a through long hole being arranged at the first connector along the first direction, the connector passes through the long hole, and a radial direction of the long hole being arranged along the second direction.

The connector and the long hole slide-cooperate in the first direction.

The connector and the long hole slide-cooperate in the second direction.

The connector and the long hole are seal-cooperate with each other.

On the second aspect, the present disclosure further provides a process chamber including:
a chamber body;
a liner structure arranged in the chamber body, dividing the chamber body into an inner chamber and an outer chamber from the inside, and including a wafer transfer opening communicating the inner chamber with the outer chamber;
a gate movably arranged in the outer chamber and configured to open and close the wafer transfer opening; and
the above gate drive mechanism driving-connected to the gate to drive the gate to open and close the wafer transfer opening.

In some embodiments, the gate includes a first position, a second position, and a third position.

At the first position, the gate is located at a position of the wafer transfer opening to close the wafer transfer opening.

At the second position, the gate is located at a position away from the wafer transfer opening in the second direction, and a moving gap is formed between the gate and an outer wall of the liner structure.

At the third position, the gate is located at a position avoid the wafer transfer opening in the first direction.

The first drive apparatus is configured to drive the gate to move between the second position and the third position.

The second drive apparatus is configured to drive the gate to move between the first position and the second position.

In some embodiments, the liner structure includes a first cooperation end surface, and the wafer transfer opening is located on the first cooperation end surface; and
the gate includes a second cooperation end surface, and at the first position of the gate, the second cooperation end surface covers the first cooperation end surface to close the wafer transfer opening.

In some embodiments, an induction coil is arranged at the second cooperation end surface of the gate, and at the first position of the gate, the gate abuts the induction coil against at the liner structure.

In some embodiments, an accommodation groove is arranged at the first cooperation end surface, and at the first position of the gate, the induction coil is located in the accommodation groove, and the induction coil abuts against at a groove bottom of the accommodation groove.

In some embodiments, a protrusion structure is arranged at the second cooperation end surface of the gate, and the induction coil is arranged at an outer periphery side of the protrusion structure.

The liner structure further includes a sealed channel, a first end of the sealed channel extends to the first cooperation end surface to form the wafer transfer opening, and a second end of the sealed channel communicates with the inner chamber.

In response to the gate being at the first position, the protrusion structure is located in the sealed channel, and the protrusion end surface of the protrusion structure is flush with an inner wall surface of the inner chamber to form a complete symmetrical space inside the inner chamber.

A first sealed gap is formed between an outer periphery wall of the protrusion structure and an inner wall of the sealed channel.

In some embodiments, from a first end to a second end of the sealed channel, a distance between inner walls opposite to each other in the sealed channel gradually decreases, and the protrusion structure is a wedge-shaped protrusion matching the sealed channel.

In some embodiments, at least one annular protrusion is arranged along an outer periphery of the protrusion structure on a second cooperation end surface of the gate, the annular protrusion being arranged at an inner side of the induction coil.

At least one annular groove is arranged at a first cooperation end surface of the liner structure, the annular protrusion is located in the corresponding annular groove, and a second sealed gap is formed between the annular protrusion and the annular groove.

In some embodiments, in response to the gate being at the second position, the protrusion structure exits the sealed channel to form the moving gap between the gate and the outer wall of the liner structure.

The second drive apparatus drives the gate to move to allow the protrusion structure to enter or exit the sealed channel.

On a third aspect, the present disclosure further provides semiconductor processing equipment including at least one above process chamber.

In the gate drive mechanism of the present disclosure, on the basis of the first drive apparatus driving the gate to move along the first direction through the connector, the second drive apparatus can drive the gate to move along the second direction through the connector. Since the connector can move in the second direction relative to the first drive apparatus without being restricted by the first drive apparatus, when driven by the second drive apparatus, the gate can move in the second direction (e.g., horizontally). Thus, the gate can cover the liner structure to seal or separate the gate from the liner. While the sealing performance of the gate is ensured, the collision between the gate and the liner structure can be effectively avoided.

### BRIEF DESCRIPTION OF THE DRAWINGS

FIG. 1 is a schematic structural diagram of a gate drive mechanism according to an embodiment of the present disclosure.
FIG. 2 is a schematic structural diagram of a second drive apparatus of a gate drive mechanism according to an embodiment of the present disclosure.
FIG. 3 is a schematic front view of a second drive apparatus of a gate drive mechanism according to an embodiment of the present disclosure.
FIG. 4 is a schematic cross-section diagram of a second shell body of a second drive apparatus of a gate drive mechanism along A-A according to an embodiment of the present disclosure.
FIG. 5 is a schematic cross-section diagram of a whole second drive apparatus of a gate drive mechanism along A-A according to an embodiment of the present disclosure.
FIG. 6 is a schematic cross-section diagram of a whole second drive apparatus of a gate drive mechanism along B-B according to an embodiment of the present disclosure.
FIG. 7 is a schematic enlarged diagram of portion A in FIG. 5.
FIG. 8 is a schematic structural diagram of a first drive apparatus of a gate drive mechanism according to an embodiment of the present disclosure.
FIG. 9 is a schematic top view of a connector of a first drive apparatus of a gate drive mechanism according to an embodiment of the present disclosure.
FIG. 10 is a schematic front view of a first drive apparatus of a gate drive mechanism according to an embodiment of the present disclosure.
FIG. 11 is a schematic cross-section diagram of a top view of a first drive apparatus of a gate drive mechanism according to an embodiment of the present disclosure.
FIG. 12 is a schematic structural diagram of a gate of a process chamber at a first position according to an embodiment of the present disclosure.
FIG. 13 is a schematic structural diagram of a gate of a process chamber at a second position according to an embodiment of the present disclosure.
FIG. 14 is a schematic structural diagram of a gate of a process chamber at a third position according to an embodiment of the present disclosure.
FIG. 15 is a schematic diagram showing a cooperation between a liner structure of a process chamber and a gate according to an embodiment of the present disclosure.
FIG. 16 is a schematic enlarged diagram of portion C in FIG. 15.
FIG. 17 is a schematic structural diagram of a gate of a process chamber according to an embodiment of the present disclosure.
FIG. 18 is a schematic enlarged diagram of portion D in FIG. 17.
FIG. 19 is a schematic enlarged diagram of portion B in FIG. 14.
FIG. 20 is a schematic structural diagram showing a cooperation between a step structure of a process chamber and a sealed channel according to an embodiment of the present disclosure.

**Reference numerals:**

| | | | | | |
|---|---|---|---|---|---|
| 10 | First drive apparatus | 11 | First connector | 111 | Long hole |
| 12 | Bracket | 13 | First driver | 131 | Shielding member |
| 14 | First sliding member | 15 | Inspection apparatus | 151 | Emission end |
| 152 | Reception end | 16 | Sliding mechanism | 17 | Servo motor |
| 20 | Second drive apparatus | 21 | Second shell body | 211 | First accommodation member |
| 212 | Second accommodation member | | | 213 | Guide hole |
| 214 | Step structure | 22 | Second driver | 221 | Piston rod |
| 23 | Connection board | 23 | a Board body | 23b | Connection arm |
| 231 | Positioning hole | 24 | Guide shaft | 25 | Installation base |
| 251 | Installation hole | 26 | Buffer ring | 27 | Positioning column |
| 28 | Positioning sleeve | 29 | Lock nut | 30 | Connector |
| 31 | Connection rod | 32 | Sliding board | 321 | Second sliding member |
| 40 | Installation space | 41 | First mounting groove | 41a | Primary groove body |
| 41b | Secondary groove body | 411 | Installation opening | 42 | Second installation groove |
| 50 | Chamber body | 51 | Inner chamber | 52 | Inner chamber |
| 60 | Liner structure | 61 | Wafer transfer opening | 62 | First cooperation end surface |
| 621 | Accommodation groove | 622 | Annular groove | 63 | Sealed channel |
| 70 | Gate | 71 | Second cooperation end surface | | |
| 72 | Step structure | 73 | Annular protrusion | 80 | Induction coil |
| 90 | Labyrinth seal structure | 91 | First seal clearance | 92 | Second seal clearance |

### DETAILED DESCRIPTION OF THE EMBODIMENTS

To allow those skilled in the art to better understand the technical solutions of the present disclosure, the gate drive mechanism, the process chamber, and the semiconductor processing equipment of the present disclosure are described in detail below in connection with the accompanying drawings.

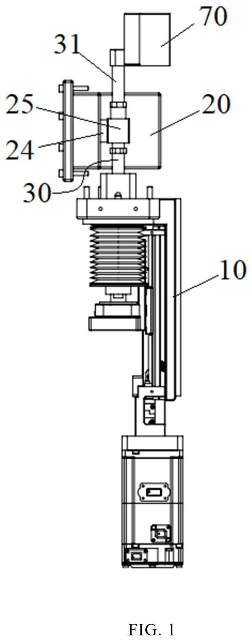

To realize the purpose of the present disclosure, as shown in FIG. 1, embodiments of the present disclosure provide a gate drive mechanism. The gate drive mechanism can be applied to various semiconductor processing equipment, such as an etching machine, to drive the gate to seal the wafer transfer opening or move away from the wafer transfer opening. The gate drive mechanism of embodiments of the present disclosure includes a first drive apparatus 10, a second drive apparatus 20, and a connector 30. The connector 30 can be configured to be connected to a gate 70 and can be drive-connected to the first drive apparatus 10. The first drive apparatus 10 can be configured to drive the connector 30 to move along a first direction to cause the connector 30 to drive the gate 70 to move along the first direction. In a second direction intersecting with the first direction, the connector 30 can be movable relative to the first drive apparatus 10. The connector 30 can also be drive-connected to the second drive apparatus 20. The second drive apparatus 20 can be configured to drive the connector 30 to move along a second direction to cause the connector 30 to drive the gate 70 to move along the second direction relative to the first drive apparatus 10.

When applied, the first drive apparatus 10 can drive the connector 30 to move. The connector 30 can drive the gate 70 to move along the first direction. When the gate 70 moves to a preset position, the first drive apparatus 10 can stop and cause the connector 30 to stop moving in the first direction. Then, the second drive apparatus 20 can drive the connector 30 to move along the second direction. Since the connector 30 can move along the second direction relative to the first drive apparatus 10, the connector 30 may not be restricted by the first drive apparatus 10. Thus, when driven by the second drive apparatus 20, the connector 30 can drive the gate 70 to move along the second direction.

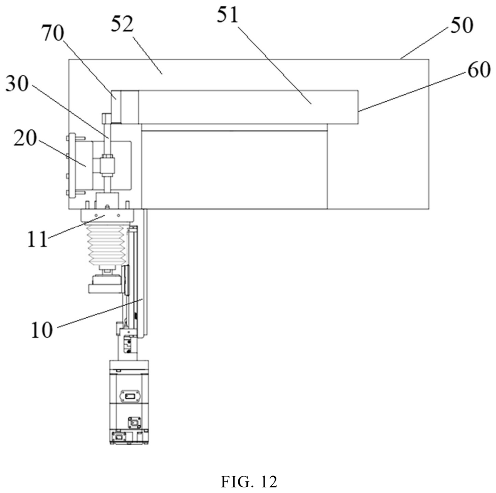

After the gate drive mechanism is mounted at the process chamber, in embodiments of the present disclosure, the first direction is the vertical direction, i.e., the up and down direction in FIG. 1, and the second direction is the horizontal direction, i.e., the left and right direction in FIG. 1. When the gate 70 is closing, the first drive apparatus 10 can be configured to drive the connector 30 and the gate 70 to move up together. After the connector 30 and the gate 70 move up to a suitable position, the second drive apparatus 20 can drive the gate 70 through the connector 30 to move horizontally (i.e., the second direction) to press the gate 70 against a liner structure 60 (referring to FIG. 12) to realize sealing. When the gate 70 is opening, the second drive apparatus 20 can first drive the gate 70 through the connector 30 to move horizontally (i.e., the second direction) to separate the gate 70 from the liner structure 60. Then, the first drive apparatus 10 can drive the second drive apparatus 20 and the gate 70 to move down together to open the gate 70.

In the gate drive mechanism of the present disclosure, the first drive apparatus 10 can be configured to drive the gate 70 through the connector 30 to move along the first direction, and the second drive apparatus 20 can be configured to drive the gate 70 through the connector 30 to move along the second direction. Since the connector 30 can move in the second direction relative to the first drive apparatus 10, the connector 30 may not be restricted by the first drive apparatus 10. Thus, when driven by the second drive apparatus 20, the gate 70 can move along the second direction (e.g., horizontally). Then, the gate 70 can be pressed against the liner structure 60 to realize the sealing, or the gate 70 can be separated from the liner structure 60. The collision and friction between the gate 70 and the liner structure 60 can be effectively avoided while ensuring the sealing effect of the gate 70.

As shown in FIG. 1, in embodiments of the present disclosure, the connector 30 includes a connection rod 31. The connection rod 31 is arranged at the second drive apparatus 20. The axial direction of the connection rod 31 is arranged along the first direction. The connection rod 31 moves in the first direction relative to the second drive apparatus 20. An end of the connection rod 31 is movably arranged at the first drive apparatus 10 along the second direction. A second end of the connection rod 31 is connected to the gate 70. That is, in FIG. 1, the connection rod 31 is arranged at the second drive apparatus 20 along the vertical direction (i.e., the first direction) in FIG. 1. The connection rod 31 can move in the vertical direction relative to the second drive apparatus 20. Thus, when the first drive apparatus 10 drives the connection rod 31 to move up and down, the restriction of the second drive apparatus 20 can be avoided for the connection rod 31. Similarly, the connection rod 31 moves along the horizontal direction (i.e., the second direction) in FIG. 1 relative to the first drive apparatus 10. When the second drive apparatus 20 drives the connection rod 31 to move horizontally, the restriction of the first drive apparatus 10 can be avoided for the connection rod 31.

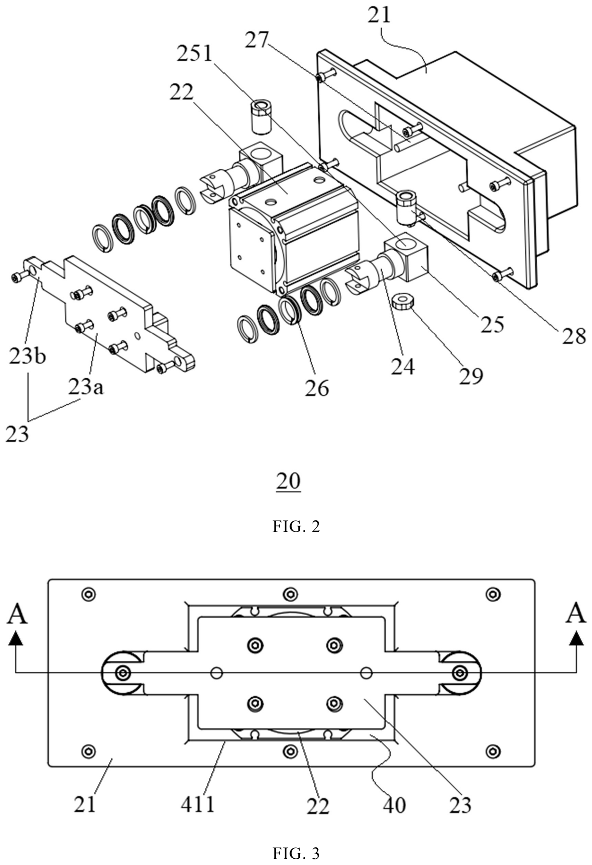

In embodiments of the present disclosure, as shown in FIG. 2, the second drive apparatus 20 includes a second shell body 21 and a second driver 22. As shown in FIG. 3, the second shell body 21 includes an installation opening 411 and an installation space 40 communicating with the installation opening 411. The second shell body 21 can be installed at a support object and can seal the installation opening 411 through the support object. The second driver 22 is arranged in the installation space 40 and can be configured to provide a drive force in the second direction to drive the connector 30 to move along the second direction.

The support object can be a member configured to mount the second shell body 21. In embodiments of the present disclosure, as shown in FIG. 12, the process chamber includes an inner chamber 51 and an outer chamber 52. The support object is an inner wall of the outer chamber 52. After the second shell body 21 is mounted at the inner wall of the outer chamber 52, the inner wall surface of the outer chamber 52 seals the installation opening 411 to isolate the installation space 40 and the outer chamber 52. On one aspect, the process gas in the process chamber can be prevented from entering the installation space 40 to have a negative impact on the inner member in the second drive apparatus 20. On another aspect, particles generated due to the friction and collision of the inner members in the second drive apparatus 20 can be prevented from entering the process chamber to affect the product.

The second drive apparatus 20 further includes a transmission assembly, which is connected between the second driver 22 and the connector 30. The second driver 22 can apply a drive force to the connector 30 through the transmission assembly in the second direction to drive the connector 30 to move along the second direction. In some embodiments, the transmission assembly includes a connection board 23, a guide shaft 24, and an installation base 25.

The connection board 23 is movably arranged in the installation space 40. The connection board 23 can be drive-connected to the second driver 22. The guide shaft 24 can pass through the second shell body 21. The axis of the guide shaft 24 can be arranged along the second direction, and the guide shaft 24 can move relative to the second shell body 21 in the second direction. The first end of the guide shaft 24 can be located inside the installation space 40 and fixedly connected to the connection board 23. The second end of the guide shaft 24 can be located outside the second shell body 21. The second end of the guide shaft 24 can be provided with an installation base 25. The connector 30 can be arranged at the installation base 25. The installation base 25 can be driven by the guide shaft 24 to move along the second direction. In the first direction, the connector 30 can move relative to the installation base 25. In the second direction, the connector 30 can be relatively fixed to the installation base 25 to allow the installation base 25 to drive the connector 30 to move along the second direction.

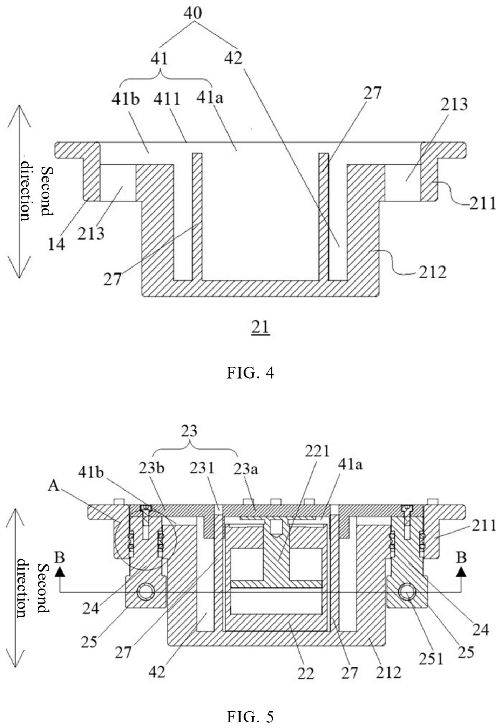

In some embodiments, as shown in FIG. 4, the second shell body 21 includes a first accommodation member 211 and a second accommodation member 212. The first accommodation member 211 includes a first end and a second end arranged oppositely along the second direction. The first end of the first accommodation member 211 can be connected to the support object. Further, in some embodiments, a first installation groove 41 is provided in the first accommodation member 211. The first installation groove 41 is the internal space of the first accommodation member 211. The opening of the first installation groove 41 is arranged on the surface of the first end of the first accommodation member 211 to form an installation opening 411. The groove bottom of the first installation groove 41 is located at the second end of the first accommodation member 211.

The second accommodation member 212 includes a first end and a second end. The first end of the second accommodation member 212 is connected to the second end of the first accommodation member 211. Further, in some embodiments, a second installation groove 42 is provided in the second accommodation member 212. The second installation groove 42 is the internal space of the second accommodation member 212. The groove opening of the second installation groove 42 is at the groove bottom of the first installation groove 41 and communicates with the first installation groove 41. The groove bottom of the second installation groove 42 is at the second end of the second accommodation member 212. The first installation groove 41 and the second installation groove 42 together form the installation space 40.

Further, in some embodiments, as shown in FIG. 4, the first installation groove 41 includes a primary groove body 41a and a secondary groove body 41b. The secondary groove body 41b is arranged at an outer periphery of the primary groove body 41a. The secondary groove body 41b communicates with the primary groove body 41a. The second installation groove 42 communicates with the primary groove body 41a.

In some embodiments, a step structure 214 is formed at the connection position between the first end of the second accommodation member 212 and the second end of the first accommodation member 211. A guide hole 213 is provided at the first accommodation member 211 along the second direction. The guide hole 213 internally communicates with the first accommodation member 211. The guide hole 213 is formed at the step structure 214. That is, as shown in FIG. 4, an end of the guide hole 213 extends to the groove bottom of the secondary groove body 41b. The other end of the guide hole 213 extends to the outer surface of the second end of the first accommodation member 211. Meanwhile, the axial direction of the guide hole 213 is arranged along the second direction.

Further, in some other embodiments, a positioning column 27 can be arranged in the second shell body 21. The positioning column 27 can be arranged along the second direction. A first end of the positioning column 27 can be connected to the groove bottom of the second installation groove 42. A second end of the positioning column 27 can extend to the position of the groove opening (i.e., the installation opening 411) of the first installation groove 41. Two positioning columns 27 can be provided. The two positioning columns 27 can be arranged at an interval inside the second accommodation member 212. Two neighboring positioning columns 27 can form a position-limiting space therebetween to install the second driver 22.

As shown in FIG. 4 and FIG. 5, in some embodiments, the second driver 22 is a cylinder. The second driver 22 is arranged inside the second installation groove 42 and is in the position-limiting space formed by the two positioning columns 27. The piston 221 of the cylinder faces the direction of the installation opening 411 and is fixedly connected to the connection board 23 to allow the piston 221 of the cylinder to drive the connection board 23 to move along the second direction.

The connection board 23 can be movably arranged in the first installation groove 41 along the second direction. In some embodiments, the connection board 23 includes a board body 23a and a connection arm 23b. The connection arm 23b can be arranged at the outer periphery of the board body 23a. The board body 23a can be arranged in the primary groove body 41a. The connection arm 23b can be arranged in the secondary groove body 41b. The board body 23a can be drive-connected to the second driver 22, and the connection arm 23b can be connected to the guide shaft 24.

In some embodiments, as shown in FIG. 5, the board body 23a of the connection board 23 is fixedly connected to the piston 221 of the cylinder. A positioning hole 231 is arranged at the board body 23a of the connection board 23. The positioning column 27 is arranged in the positioning hole 231. The connection board 23 is movable relative to the positioning column 27. Positioning and guidance can be performed through the cooperation between the positioning column 27 and the positioning hole 231. When the connection board 23 is installed, the positioning hole 231 may need to be aligned with the positioning column 27 to install the connection board 23 inside the first installation groove 41.

As shown in FIG. 5, the guide shaft 24 passes through the guide shaft 24 passes through inside the guide hole 213, and the guide shaft 24 moves in the second direction relative to the second shell body 21. As shown in FIG. 3, the first end of the guide shaft 24 is arranged in the secondary groove body 41b of the first installation groove 41 and is fixedly connected to the connection body 23. As shown in FIG. 5, the second end of the guide shaft 24 is outside the second shell body 21. As shown in FIG. 1 and FIG. 5, the installation base 25 is arranged at the second end of the guide shaft 24, and the connector 30 is arranged at the installation base 25. The installation base 25, which is driven by the guide shaft 24, moves in the second direction.

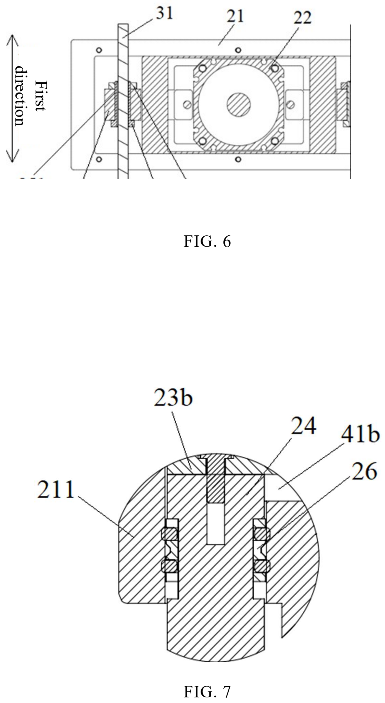

It needs to be noted that, as shown in FIG. 6, a through installation hole 251 is arranged at the installation base 25 along the first direction. The connector 30 passes through the installation hole 251 and moves along the first direction in the installation hole 251. Then, the connector 30 is movable relative to the installation base 25 in the first direction. In the second direction, the connector 30 is fixed relative to the installation base 25 to allow the installation base 25 to drive the connector 30 to move in the second direction.

It also needs to be noted that, to ensure the stability of the movement of the connector 30, as shown in FIG. 2, the positioning sleeve 28 and the locking nut 29 are arranged in the installation hole 251. The positioning sleeve 28 is arranged between the connector 30 and the installation hole 251. The locking nut 29 is arranged at the positioning sleeve 28 to prevent the connector 30 from shaking in the installation hole 251.

In some embodiments, the guide shaft 24 can be sealed from the second shell body 21. For example, as shown in FIG. 7, a seal ring is arranged between the guide shaft 24 and the guide hole 213 to ensure the sealability of the installation space 40. However, to ensure the stability of the movement of the guide shaft 24 in the second direction, a buffer ring 26 is arranged at the guide shaft 24. The buffer ring 26 is arranged between the guide shaft 24 and the inner wall of the guide hole 213.

In some embodiments, as shown in FIG. 5 and FIG. 6, two connection rods 31 are provided. The two connection rods 31 are arranged at an interval to ensure the gate 70 is subject to the force uniformly, and the operation is more stable. Correspondingly, two guide holes 213 and two guide shafts 24 are provided. The second accommodation member 212 is arranged between two guide shafts 24. With such an arrangement, not only the installation of the second shell body 21 is facilitated, but also the space between the two connection rods 31 can be sufficiently used to accommodate the second shell body 21. Thus, the space can be sufficiently used in the narrow process chamber to realize the horizontal movement. While the seal performance of the gate 70 is improved, the collision and friction between the gate 70 and the liner structure 60 can also be effectively avoided.

In addition, the positioning column 27 can be arranged to limit the position of the cylinder to facilitate the installation and fixation of the cylinder. Through the cooperation between the positioning column 27 and the positioning hole 231, the positioning of the connection board 23 can be facilitated during installation. Moreover, the two positioning columns 27 can be arranged in parallel to ensure the installation angle of the connection board 23 is perpendicular to the second direction. Thus, the positions of the guide shafts 24 connected to the two sides of the connection board 23 can be ensured to be the same to further ensure the positions of the two connection rods 31 are the same. Then, the seal performance of the cooperation between the gate 70 and the liner structure 60 can be ensured, representing a typical example of multi-functional design.

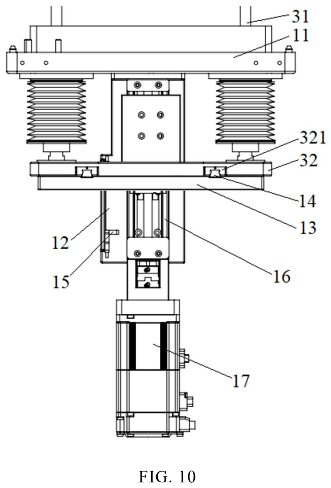

In some embodiments, the first drive apparatus 10 can include a first driver 13. The first driver 13 can be movably arranged along the first direction. A first slider 14 can be arranged at the first driver 13. Further, in some embodiments, to realize the movement of the connector 30 relative to the first driver 13, as shown in FIG. 10, a second slider 321 is arranged at the connector 30 (e.g., the connection rod 31). The first slider 14 and the second slider 321 can cooperate in the first direction with position restriction, and the first slider 14 and the second slider 321 can slide-cooperate in the second direction to allow the first driver 13 to drive the connector 30 (e.g., the connection rod 31) to move in the first direction. The connector 30 (e.g., the connection rod 31) can slide in the second direction relative to the first driver 13.

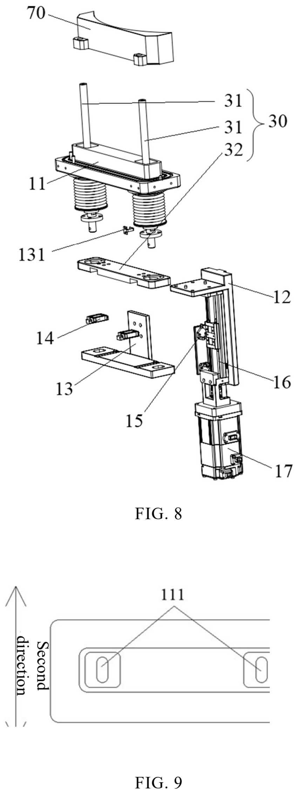

In some embodiments, as shown in FIG. 8, the first slider 14 is a sliding track arranged along the second direction. The second slider 321 is a sliding groove matching the first slider 14. The sliding track is fixedly arranged at the first driver 13 along the second direction. To ensure the stability, as shown in FIG. 10, two sliding tracks are arranged at an interval. In practical applications, the first slider 14 can be the sliding groove arranged along the second direction, and the second slider 321 can be the sliding tracks matching the first slider 14.

In some embodiments, as shown in FIG. 1 and FIG. 8, the gate drive mechanism further includes a first connector 11. The first connector 11 can be configured to be connected to the support object. The first connector 11 and the connector 30 (e.g., the connection rod 31) can slide-cooperate in the first direction. The first connector 11 and the connector 30 (e.g., the connection rod 31) can slide-cooperate in the second direction. In some embodiments, a long hole 111 passing through along the first direction can be arranged at the first connector 11. The connector 30 (e.g., the connection rod 31) can pass through the long hole 111. The radial direction of the long hole 111 can be arranged along the second direction. The connector 30 and the long hole 111 can slide-cooperate in the first direction. The connector 30 and the long hole 111 can slide-cooperate in the second direction. The connector 30 and the long hole 111 can be sealed and cooperate with each other.

In embodiments of the present disclosure, as shown in FIG. 1, FIG. 8, and FIG. 9, the first connector 11 is an installation board. A long hole 111 (see FIG. 9) passing through the installation board is provided at the installation board along the first direction (i.e., the up and down direction in FIG. 1). The connector 30 is arranged in and passes through the long hole 111. The radial direction of the long hole 111 is arranged along the second direction (i.e., the up and down direction in FIG. 9). The connector 30 and the long hole 111 can slide-cooperate in the first direction to allow the connector 30 to move when driven by the first driver 13. The connector 30 and the long hole 111 can slide-cooperate in the second direction. That is, the whole can move left and right in FIG. 1 to allow the connector 30 to move when driven by the second driver 22. The connector 30 and the long hole 111 can be sealed and cooperate to prevent the process gas from leaking from the long hole 111 after the installation board is mounted at the process chamber. In some embodiments, as shown in FIG. 1 and FIG. 8, the connector 30 and the long hole 111 are sealed by bellows to ensure sealability and movement.

In some embodiments, the first drive apparatus 10 further includes a bracket 12. As shown in FIG. 10, the first connector 11 is fixed at a first end of the bracket 12 through, for example, a screw.

As shown in FIG. 12, when being mounted in the process chamber, the first connector 11 is connected to the chamber body 50. An opening is arranged at the bottom of the chamber body 50. The outer chamber 52 communicates with the outer side through the opening. The first connector 11 is mounted at the position of the opening of the chamber body 50. The bracket 12 is fixedly connected to the chamber body 50 through the first connector 11.

The connection rod 31 of the connector 30 passes through the first connector 11 and the chamber body 50. The first connector 11 can slide-cooperate with the connector 30 in the first direction. The first connector 11 can slide-cooperate with the connector 30 in the second direction.

Further, in some embodiments, as shown in FIG. 10, the first drive apparatus 10 further includes a sliding mechanism 16 and a servo motor 17. The servo motor 17 is fixed at the second end of the bracket 12. The sliding mechanism 16 is mounted at the bracket 12 between the first end and the second end of the bracket 12. The servo motor 17 drives and is connected to the sliding mechanism 16. The first driver 13 is fixedly connected to the sliding mechanism 16. That is, the first driver 13 is movably arranged at the bracket 12 through the sliding mechanism 16. The connector 30 (e.g., the connection rod 31) is arranged at the first driver 13. The first driver 13 is configured to drive the connector 30 to move in the first direction. The connector 30 is movable at the first driver 13 along the second direction.

In application, the servo motor 17 can drive the sliding mechanism 16 to allow the sliding mechanism 16 to drive the first driver 13 to move between the first end and the second end of the bracket 12. The moving first driver 13 can drive the connector 30 to move in the first direction. After the connector 30 moves to the preset position, when being driven by the second drive apparatus 20, the connector 30 can move at the first driver 13 along the second direction to drive the gate 70 to move along the second direction.

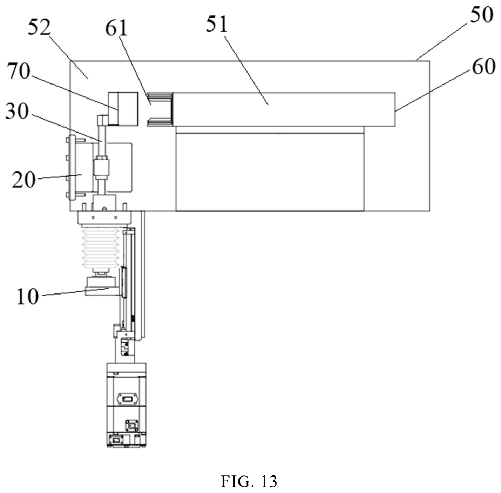

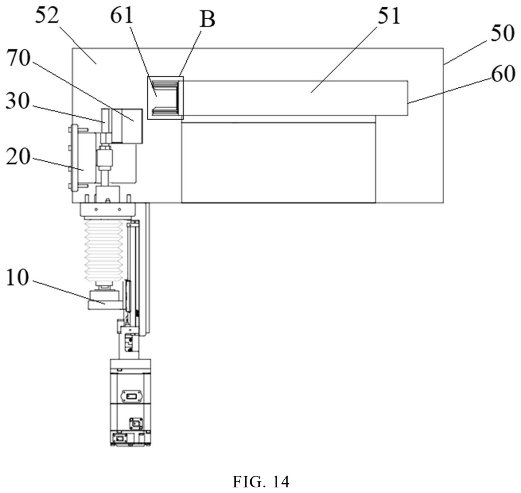

After being mounted in the process chamber, the servo motor 17 can drive the sliding mechanism 16 to allow the sliding mechanism 16 to drive the first driver 13 to move. The moving first driver 13 can drive the connector 30 to move in the first direction to allow the connector 30 to drive the gate 70 to move between the position shown in FIG. 13 and the position shown in FIG. 14. When the first driver 13 moves to the first end of the bracket 12, the connector 30 can drive the gate 70 to move to the position shown in FIG. 13. Then, when being driven by the second drive apparatus 20, the connector 30 can move at the first driver 13 along the second direction to drive the gate 70 to move to the position shown in FIG. 12 along the second direction to close the wafer transfer opening 61.

The connector 30 can include a connection rod 31 and a sliding board 32. Two connection rods 31 can be provided. The first ends of the two connection rods 31 can be fixedly connected to the gate 70. The second ends of the two connection rods 31 can be fixedly connected to the sliding board 32. That is, the sliding board 32 can be fixedly connected to the second end of the connection rod 31. The sliding board 32 can be movably arranged at the sliding track along the second direction. Moreover, the sliding groove can be arranged at the sliding board 32. The sliding track can be arranged in the sliding groove and slide-cooperate with the sliding groove. That is, the sliding board 32 can be movably arranged at the first driver 13 through the sliding track. The connection rod 31 can be fixedly connected to the sliding board 32 to realize the movement relative to the first driver 13 in the second direction. Then, the two connection rods 31 can move synchronously to ensure the gate 70 moves stably. Further, in some embodiments, the cross-section of the sliding track can have a T-shape structure.

In embodiments of the present disclosure, the first slider 14 can be the sliding track arranged at the first driver 13 along the second direction. The second slider 321 can be the sliding groove arranged at the sliding board 32 and cooperating with the first slider 14, which is not limited. In some other embodiments not shown in the figures, the first slider 14 can also be the sliding groove, and the second slider 321 can be the sliding track, as long as the first slider 14 and the second slider 321 are position-restricted and cooperate in the first direction, and the first slider 14 and the second slider 321 are structures that slide-cooperate in the second direction, which are all within the scope of the present disclosure.

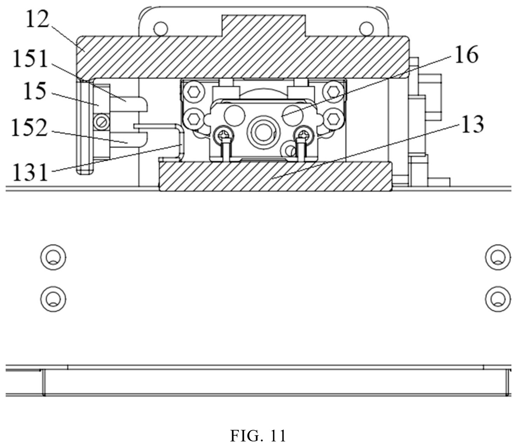

To facilitate obtaining the position of the gate 70, as shown in FIG. 8, the first drive apparatus 10 further includes a detection apparatus 15. The detection apparatus 15 is arranged at the bracket 12. The detection apparatus 15 can be configured to detect the position of the first driver 13 to indirectly obtain the position of the gate 70. In some embodiments, as shown in FIG. 11, the detection apparatus 15 is an optical sensor, which includes an emission end 151 and a reception end 152 arranged oppositely. A detection space is formed between the emission end 151 and the reception end 152. A shielding member 131 is arranged at the first driver 13. When the first driver 13 moves to the position opposite to the detection apparatus 15, the shielding member 131 is in the detection space to detect the position of the first driver 13 to indirectly obtain the position of the gate 70.

In some embodiments, as shown in FIG. 8, two detection apparatuses 15 are provided. The two detection apparatuses are arranged at the bracket at an interval. The two detection apparatuses 15 correspond to the upper position-limiting position and the lower position-limiting position of the first driver 13 moving in the first direction, respectively, that is, the two limiting positions of the gate 70 in the first direction, which are not restricted. In some other embodiments, the detection apparatuses 15 can also be only arranged at the positions close to the first end of the bracket 12 to allow the detection apparatus 15 to detect whether the first driver 13 is located at the upper position-limiting position in the first direction. Then, the position corresponding to the gate 70 has the same height as the wafer transfer opening to facilitate the control of the movement of the second drive apparatus 20.

As shown in FIG. 12 to FIG. 14, the present disclosure further provides a process chamber, including a chamber body 50, a liner structure 60, a gate 70, and the gate drive mechanism. The liner structure 60 is arranged in the chamber body 50. The liner structure 60 divides the chamber body 50 into an inner chamber 51 and an outer chamber 52. A wafer transfer opening 61 communicating the inner chamber 51 with the outer chamber 52 is arranged at the liner structure 60. The gate 70 is movably arranged in the outer chamber 52. The gate 70 is configured to open and close the wafer transfer opening 61. The gate drive mechanism can drive and be connected to the gate 70 to drive the gate 70 to open and close the wafer transfer opening 61.

In the process chamber of the present disclosure, the gate drive mechanism of the present disclosure can drive and be connected to the gate 70. Then, the gate 70 can move horizontally (i.e., the second direction) to allow the gate 70 to abut against the liner structure 60 to seal or separate the gate 70 and the liner structure. While ensuring the seal performance of the gate 70, the collisions and scratches between the gate 70 and the liner can also be avoided.

In some embodiments, as shown in FIG. 12 and FIG. 13, the gate 70 has a first position, a second position, and a third position.

As shown in FIG. 12, at the first position, the gate 70 is at the position of the wafer transfer opening 61 to close the wafer transfer opening 61.

As shown in FIG. 13, at the second position, the gate 70 is at a position away from the wafer transfer opening 61 in the second direction. A moving gap is formed between the gate 70 and the outer wall of the liner structure 60.

As shown in FIG. 14, at the third position, the gate 70 is at the position of the wafer transfer opening 61 in the first direction. The first drive apparatus 10 is configured to drive the gate 70 to move between the second position and the third position. The second drive apparatus 20 is configured to drive the gate 70 to move between the first position and the second position.

In some embodiments, the process chamber of the present disclosure can further include a control apparatus. The control apparatus can be electrically connected to the detection apparatus 15, the servo motor 17, and the second drive apparatus 20. The control apparatus can be configured to control the second drive apparatus 20 to drive the gate 70 to switch between the first position and the second position according to the position of the first driver 13.

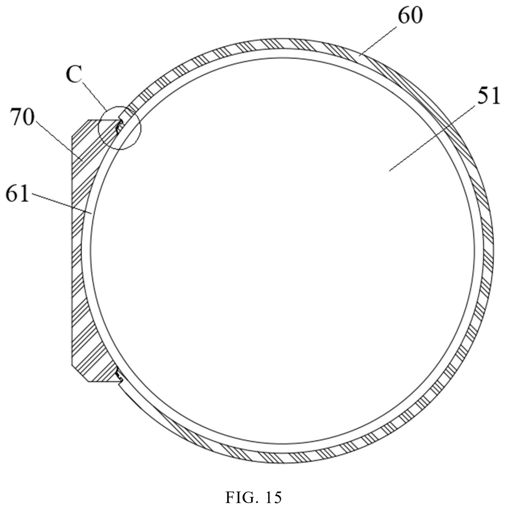

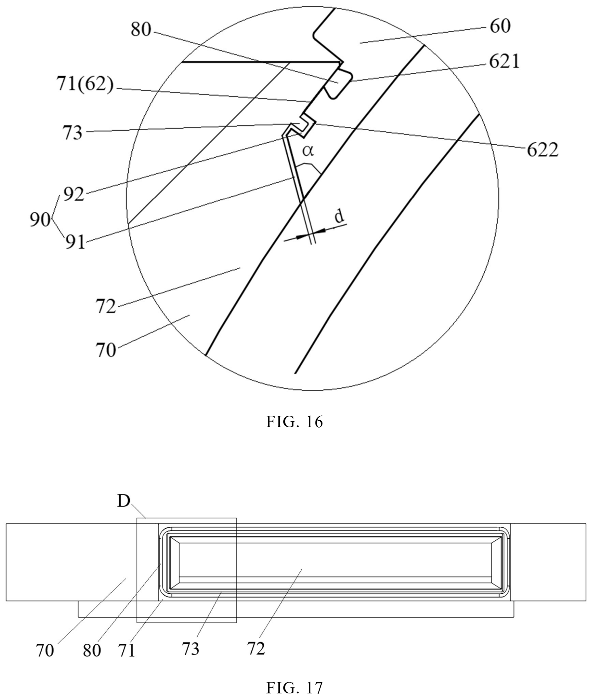

In some embodiments, as shown in FIG. 15 and FIG. 16, the liner structure 60 includes a first cooperation end surface 62. The wafer transfer opening 61 is arranged at the first cooperation end surface 62. The gate 70 includes the second cooperation end surface 71. At the first position of the gate 70, the second cooperation end surface 71 covers the first cooperation end surface 62 to close the wafer transfer opening 61.

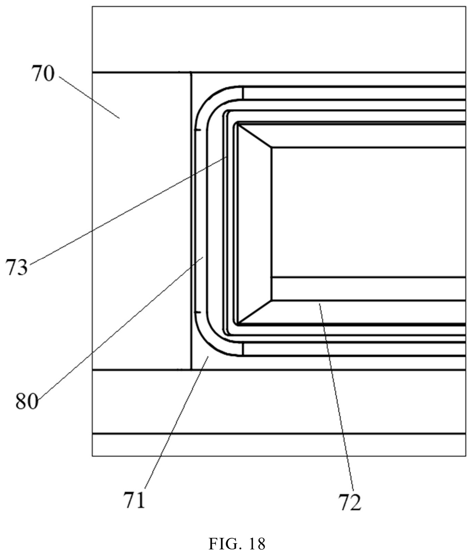

In some embodiments, as shown in FIG. 17 and FIG. 18, an induction coil 80 is arranged at the second cooperation end surface 71 of the gate 70. At the first position of the gate 70, the gate 70 abuts the induction coil 80 against the liner structure 60. By providing the induction coil 80, at the first position of the gate 70, the gate 70 abuts the induction coil 80 at the liner structure 60 to establish an electrical connection between the liner structure 60 and the gate 70 to create a complete closed radio frequency environment.

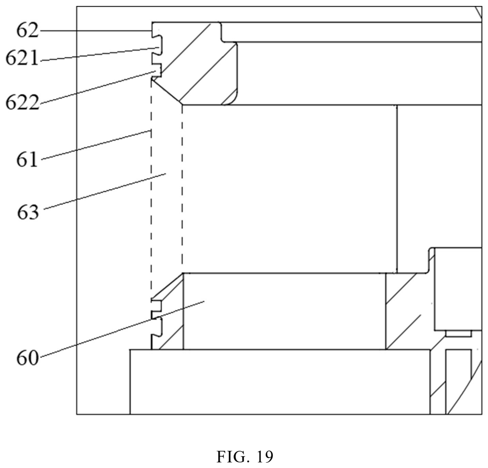

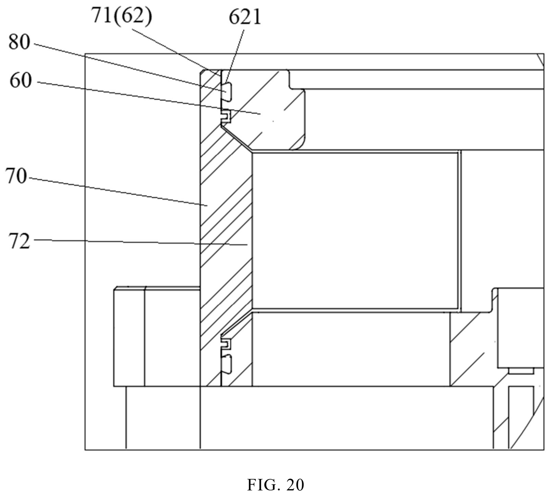

In some embodiments, as shown in FIG. 19, an accommodation groove 621 is provided at the first cooperation end surface 62. As shown in FIG. 20, at the first position of the gate 70, the induction coil 80 is arranged in the accommodation groove 621. Meanwhile, the induction coil 80 abuts against the groove bottom of the accommodation groove 621. By providing the accommodation groove 621 at the first cooperation end surface 62, when the gate 70 is at the first position, the induction coil 80 is in the accommodation groove 621 and abuts against the groove bottom of the accommodation groove 621. Thus, the first cooperation end surface 62 is attached to the second cooperation end surface 71 to improve the seal performance.

In some embodiments, as shown in FIG. 17 and FIG. 18, a protrusion structure 72 is arranged at the second cooperation end surface 71 of the gate 70. The induction coil 80 is arranged at the outer periphery of the protrusion structure 72. As shown in FIG. 19, the liner structure 60 further includes a sealed channel 63. The first end of the sealed channel 63 extends to the first cooperation end surface 62 to form the wafer transfer opening 61. The second end of the sealed channel 63 communicates with the inner chamber 51. As shown in FIG. 20, at the first position of the gate 70, the protrusion structure 72 is arranged in the sealed channel 63. The surface of the protrusion end of the protrusion structure 72 is flush with the inner wall surface of the inner chamber 51 to form a complete symmetrical space inside the inner chamber 51. A first sealed gap 91 (see FIG. 16) is formed between the outer periphery wall of the protrusion structure 72 and the inner wall of the sealed channel 63. By forming the first sealed gap 91 between the protrusion structure 72 and the sealed channel 63, on one hand, the first sealed gap 91 can be used to prevent the liner structure from colliding with the gate 70 to generate particles to contaminate the wafer. On the other hand, the first sealed gap 91 can be used to block the plasma in the process gas from passing through to protect the induction coil 80.

As shown in FIG. 16, from the first end of the sealed channel 63 to the second end, the distance between the opposite walls arranged in the sealed channel 63 gradually reduces. The protrusion structure 72 is a wedge-shaped protrusion matching the sealed channel 63. That is, the inner wall of the sealed channel 63 is inclined. In embodiments of the present disclosure, the distance between the outer periphery wall of the protrusion structure 72 and the inner wall of the sealed channel 63 is d. d ranges from 0.5 to 1.3 mm. An angle is formed between the inner wall of the sealed channel 63 and the tangent of the arc at the position. α ranges from 30° to 60°. Thus, the depth-to-width ratio of the gap can increase to annihilate the plasma.

As shown in FIG. 16 to FIG. 20, an annular protrusion 73 is formed on the second cooperation end surface 71 of the gate 70 along the outer periphery of the protrusion structure 72. The annular protrusion 73 is formed at the inner side of the induction coil 80. The first cooperation end surface 62 of the liner structure 60 is provided with an annular groove 622. The annular protrusion 73 is arranged in the annular groove 622, and a second sealed gap 92 is formed between the annular protrusion 73 and the annular groove 622. The first sealed gap 91 communicates with the second sealed gap 92 to form a labyrinth sealed structure 90. By providing the first sealed gap 91 and the second sealed gap 92, the first sealed gap 91 and the second sealed gap 92 can communicate with each other to form the labyrinth sealed structure 90 to increase the travel distance for the process gas to flow to the induction coil 80. Thus, the flow resistance can be increased, and the difficulty for the process gas to reach the induction coil 80 can also be increased. Meanwhile, the probability of annihilating the plasma can be increased to better protect the induction coil 80.

As shown in FIG. 13 and FIG. 19, at the second position of the gate 70, the protrusion structure 72 is detached from the sealed channel 63 to form the moving gap between the gate 70 and the outer wall of the liner structure 60. The second drive apparatus 20 can drive the gate 70 to move to allow the protrusion structure 72 to enter the sealed channel 63 or exit from the sealed channel 63.

The gate 70 can be ensured to compress tightly, and the induction coil 80 can be ensured to have a certain compression amount (the compression amount ranges from 20% to 25%). Meanwhile, since the protrusion structure 72 needs to enter the sealed channel 63, to keep the first sealed channel to range from 0.5 to 1.3 mm. The cooperation precision between the gate 70 and the liner structure 60 may need to be improved. Thus, the conventional gate structure can be divided into the first drive apparatus 10 configured to drive the gate 70 to move along the first direction and the second drive apparatus 20 configured to drive the gate 70 to move along the second direction. The lifting height of the gate 70 in the first direction can be accurately controlled by the servo motor 17 of the first drive apparatus 10. With the added second drive apparatus 20, the gate 70 can be ensured to move steadily in the second direction. Meanwhile, the induction coil 80 at the arc surface can be compressed to ensure the entirety of the radio frequency loop to further improve the uniformity of the processes.

The present disclosure further provides a semiconductor processing equipment, including at least one process chamber. By providing the second drive apparatus 20, the gate 70 can move horizontally to compress the gate 70 at the liner structure 60 to seal or detach the gate 70 and the liner structure 60. While the sealing performance of the gate 70 is ensured, the collisions and scratches between the gate 70 and the liner structure 60 can be effectively avoided.

The above embodiments are merely exemplary embodiments for describing the principle of the present disclosure. However, the present disclosure is not limited to this. Those of ordinary in the art can make various modifications and improvements without departing from the spirit and essence of the present disclosure. These modifications and improvements are also within the scope of the present disclosure.

## Claims

1. A gate drive mechanism comprising:
a first drive apparatus;
a second drive apparatus; and
a connector configured to be connected to a gate and driving-connected to the first drive apparatus and the second drive apparatus;
wherein:
the first drive apparatus is configured to drive the connector to move along a first direction to allow the connector to drive the gate to move along the first direction; and
the second drive apparatus is configured to drive the connector to move along a second direction, the second direction intersecting with the first direction, to allow the connector to drive the gate to move along the second direction relative to the first drive apparatus.

2. The gate drive mechanism according to claim 1, wherein the second drive apparatus includes:
a second shell body including an installation opening and an installation space communicating with the installation opening and configured to be mounted at a support object, the support object being configured to close the installation opening; and
a second driver arranged in the installation space and configured to provide a drive force in the second direction to drive the connector to move along the second direction.

3. The gate drive mechanism according to claim 2, wherein:
the second drive apparatus further includes a transmission assembly connected between the second driver and the connector; and
the transmission assembly includes:
a connection board movably arranged in the installation space and driving-connected to the second driver; and
a guidance shaft passing through the second shell body, an axis of the guidance shaft being arranged along the second direction and the guidance shaft being movable along the second direction relative to the second shell body, a first end of the guidance shaft being in the installation space and fixedly connected to the connection board, a second end of the guidance shaft being arranged outside of the second shell body, an installation base being arranged at the second end of the guidance shaft, the connector being arranged at the installation base, and the installation base driven by the guidance shaft being movable along the second direction;
wherein:
in the first direction, the connector and the installation base move relatively; and
in the second direction, the connector and the installation base are relatively fixed to allow the installation base to drive the connector to move along the second direction.

4. The gate drive mechanism according to claim 3, wherein the second shell body includes:
a first accommodation member including a first end and a second end arranged oppositely along the second direction, the first end of the first accommodation member being connected to the support object, and the installation opening being provided at the first end of the first accommodation member; and
a second accommodation member including a first end and a second end arranged oppositely along the second direction, the first end of the second accommodation member being connected to the second end of the first accommodation member;
wherein:
the first accommodation member communicates with the second accommodation member internally to form the installation space;
the connection board is movably arranged in the first accommodation member along the second direction; and
the second driver is arranged in the second accommodation member.

5. The gate drive mechanism according to claim 4, wherein a step structure is formed at a connection position between the first end of the second accommodation member and the second end of the first accommodation member, a guidance hole communicating with the first accommodation member internally is arranged at the first accommodation member along the second direction, the guidance hole is formed at the step structure, and the guidance shaft passes through the guidance hole along the second direction.

6. The gate drive mechanism according to claim 4, wherein the connection board includes a board body and a connection arm, the connection arm is arranged at an outer periphery of the board body, the board body and the second driver are driving-connected, and the connection arm is connected to the guidance shaft.

7. The gate drive mechanism according to claim 6, wherein a first installation groove is arranged in the first accommodation member, a groove opening of the first installation groove is located on a surface of a first end of the first accommodation member to form the installation opening, a groove bottom of the first installation groove is located at a second end of the first accommodation member, the first installation groove includes a main groove body and a secondary groove body, and the secondary groove body is arranged at a periphery of the main groove;
a second installation groove is arranged in the second accommodation member, a groove opening of the second installation groove is located at a groove bottom of the second installation groove and communicates with the main groove body, the groove bottom of the second installation groove is located at a second end of the second accommodation member, and the first installation groove and the second installation groove form the installation space together; and
the board body is arranged in the main groove body, and the connection arm is arranged in the secondary groove body.

8. The gate drive mechanism according to claim 3, wherein:
The guidance shaft is sealed from the second shell body.

9. The gate drive mechanism according to claim 4, wherein:
a positioning column is arranged in the second shell body along the second direction; and
a positioning hole is formed on the connection board, the positioning column is arranged in the positioning hole, and the connection board is movable relative to the positioning column to perform positioning and guidance through cooperation between the positioning column and the positioning hole.

10. The gate drive mechanism according to claim 9, wherein:
two positioning columns are provided and arranged in the second accommodation member at an interval, and a position-limiting space for mounting the second driver is formed between the two neighboring positioning columns.

11. The gate drive mechanism according to claim 3, wherein:
the connector includes a connection rod, an installation hole passes through the installation base along the first direction, the connection rod passes through the installation hole, and the connector is movable in the installation hole along the first direction.

12. The gate drive mechanism according to claims 1 to 11, wherein the first drive apparatus includes:
a first driver arranged movably along the first direction, a first slider being arranged at the first driver; and
a second slider is arranged at the connector, the first slider and the second slider position-limiting-cooperate in the first direction, the first slider and the second slider slide-cooperate in the second direction to allow the first driver to drive the connector to move along the first direction, and the connector slides in the second direction relative to the first driver.

13. The gate drive mechanism according to claim 12, wherein the connector includes:
a connection rod, a first end of the connection rod being connected to the gate; and
a sliding board fixedly connected to a second end of the connection rod, the second slider being arranged at the sliding board;
wherein the first slider is a sliding track or sliding groove arranged in the second direction, and the second slider is a sliding groove or a sliding track matching the first slider.

14. The gate drive mechanism according to claim 13, wherein the first drive apparatus further includes:
a bracket, the first driver being movably arranged at the bracket along the first direction; and
a detection apparatus arranged at the bracket and configured to detect apposition of the first driver.

15. The gate drive mechanism according to claims 1 to 11, further comprising:
a first connector connected to a support object, a through long hole being arranged at the first connector along the first direction, the connector passes through the long hole, and a radial direction of the long hole being arranged along the second direction;
the connector and the long hole slide-cooperate in the first direction;
the connector and the long hole slide-cooperate in the second direction; and
the connector and the long hole seal-cooperate with each other.

16. A process chamber comprising:
a chamber body;
a liner structure arranged in the chamber body, dividing the chamber body into an inner chamber and an outer chamber from the inside, and including a wafer transfer opening communicating the inner chamber with the outer chamber;
a gate movably arranged in the outer chamber and configured to open and close the wafer transfer opening; and
the gate drive mechanism according to any one of claims 1 to 15 driving-connected to the gate to drive the gate to open and close the wafer transfer opening.

17. The process chamber according to claim 16, wherein:
the gate includes a first position, a second position, and a third position;
at the first position, the gate is located at a position of the wafer transfer opening to close the wafer transfer opening;
at the second position, the gate is located at a position away from the wafer transfer opening in the second direction, and a moving gap is formed between the gate and an outer wall of the liner structure;
at the third position, the gate is located at a position avoid the wafer transfer opening in the first direction;
the first drive apparatus is configured to drive the gate to move between the second position and the third position; and
the second drive apparatus is configured to drive the gate to move between the first position and the second position.

18. The process chamber according to claim 17, wherein:
the liner structure includes a first cooperation end surface, and the wafer transfer opening is located on the first cooperation end surface; and
the gate includes a second cooperation end surface, and at the first position of the gate, the second cooperation end surface covers the first cooperation end surface to close the wafer transfer opening.

19. The process chamber according to claim 18, wherein an induction coil is arranged at the second cooperation end surface of the gate, and at the first position of the gate, the gate abuts the induction coil against at the liner structure.

20. The process chamber according to claim 19, wherein an accommodation groove is arranged at the first cooperation end surface, and at the first position of the gate, the induction coil is located in the accommodation groove, and the induction coil abuts against at a groove bottom of the accommodation groove.

21. The process chamber according to claim 19, wherein a protrusion structure is arranged at the second cooperation end surface of the gate, and the induction coil is arranged at an outer periphery side of the protrusion structure;
the liner structure further includes a sealed channel, a first end of the sealed channel extends to the first cooperation end surface to form the wafer transfer opening, and a second end of the sealed channel communicates with the inner chamber;
in response to the gate being at the first position, the protrusion structure is located in the sealed channel, a protrusion end surface of the protrusion structure is flush with an inner wall surface of the inner chamber to form a complete symmetrical space inside the inner chamber; and
a first sealed gap is formed between an outer periphery wall of the protrusion structure and an inner wall of the sealed channel.

22. The process chamber according to claim 21, wherein from a first end to a second end of the sealed channel, a distance between inner walls opposite to each other in the sealed channel gradually decreases, and the protrusion structure is a wedge-shaped protrusion matching the sealed channel.

23. The process chamber according to claim 21, wherein at least one annular protrusion is arranged along an outer periphery of the protrusion structure on a second cooperation end surface of the gate, the annular protrusion being arranged at an inner side of the induction coil; and
at least one annular groove is arranged at a first cooperation end surface of the liner structure, the annular protrusion is located in the corresponding annular groove, and a second sealed gap is formed between the annular protrusion and the annular groove.

24. The process chamber according to claim 21, wherein in response to the gate being at the second position, the protrusion structure exits the sealed channel to form the moving gap between the gate and the outer wall of the liner structure; and
the second drive apparatus drives the gate to move to allow the protrusion structure to enter or exit the sealed channel.

25. A semiconductor processing equipment comprising the process chamber according to any one of claims 16 to 24.
